Europäisches Patentamt

European Patent Office

Office européen des brevets

(11) Publication number: **0 446 652 A1**

# EUROPEAN PATENT APPLICATION

(21) Application number: **91102238.2**

(51) Int. Cl.5: **H03F 1/08, H03F 3/45**

(22) Date of filing: **18.02.91**

(30) Priority: **13.03.90 IT 1965890**

(43) Date of publication of application:
**18.09.91 Bulletin 91/38**

(84) Designated Contracting States:
**DE FR GB SE**

(71) Applicant: SGS-THOMSON
MICROELECTRONICS s.r.l.
Via C. Olivetti, 2
I-20041 Agrate Brianza Milano(IT)

(72) Inventor: Nicollini, Germano
Via A. Pavesi 6
I-29100 Piacenza(IT)
Inventor: Castello, Rinaldo
Via C. Battisti 48
I-20043 Arcore Milano(IT)

(74) Representative: Forattini, Amelia et al
c/o Internazionale Brevetti Ingg. ZINI,
MARANESI & C. S.r.l. Piazza Castello 1
I-20121 Milano(IT)

(54) CMOS transconductance operational amplifier.

(57) The amplifier includes a first differential stage, formed by two transistors (T1 and T2) which are biased by a current source (T3) and which have a load constituted by a current mirror which is formed by two transistors (T4 and T5) with an MCAS cascode, and a second single-ended stage which is driven by the first stage and is formed by a transistor (T6) which is biased by a current source (T7). For frequency compensation, a first capacitor ($C_{c1}$) is connected between the source of the MCAS cascode of the first stage and the output node of the second stage, and a second capacitor ($C_{c2}$) is connected between the output node of the second stage and the input node of the second stage.

Fig.4

EP 0 446 652 A1

The present invention relates to a CMOS transconductance operational amplifier.

One of the basic blocks in the constitution of integrated circuits, whether bipolar or CMOS, is, as is known, the operational amplifier, which in the case of purely capacitive loads should be conveniently provided as a transconductance amplifier, in view of its economy, in terms both of area occupation and of power dissipation, with respect to a conventional amplifier.

Typical known examples of transconductance operational amplifiers are illustrated in the article by P.R. Gray and R.G. Meyer, "MOS Operational Amplifier Design - A Tutorial Overview" in IEEE Journal of Solid-State Circuits, vol. SC 17, no. 6, Dec. 82. So-called cascode and folded-cascode amplifiers have the disadvantage of a low output dynamics, but on the other hand they have the advantage that frequency compensation is very simple, since they have a single gain stage. Said compensation is in fact normally obtained by means of a capacitor between the output and the ground, but the load itself can indeed be used for compensation if it is capacitive.

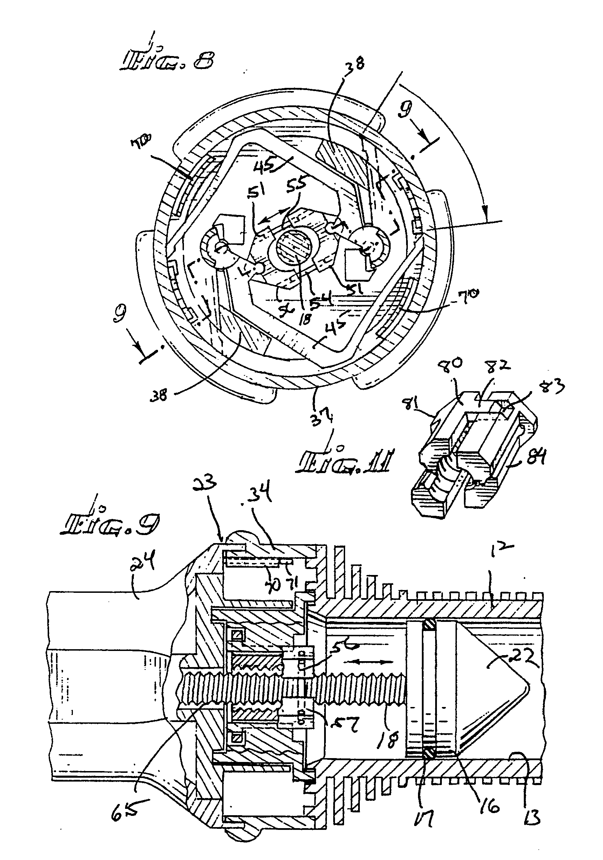

Fig. 1 illustrates another type of known transconductance amplifier, described in the above mentioned publication (and described in greater detail hereinafter), which has the advantage of a high signal swing allowed in output. However, this is an amplifier with a double gain stage, which requires, as is known to the man of the art, a Miller-type compensation between the output node of the amplifier and the output node of the first stage. As is known, said compensation is troublesome when the load comprises a highly capacitive element.

The trend of designers was therefore to use single-stage transconductance amplifiers, due to their easy compensation, when high output dynamics was not required, and to choose instead the two-stage amplifier, with the associated frequency compensation problems, in the opposite case.

D.B. Ribner and M.A. Copeland, "Design Techniques for Cascoded CMOS Op. Amps. with Improved PSRR and Common-Mode Input Range", in the IEEE Journal of Solid-State Circuits, Vol. SC 19, no. 6, Dec. 84. describe a transconductance operational amplifier, which partially solves the above described problems of the above mentioned two-stage transconductance amplifier, the circuit diagram whereof is illustrated in Fig. 3. As will be explained in greater detail hereinafter, this last amplifier would be effective only if the transconductance of the MCAS MOS cascode were very high and the parasite capacitor at the output of the first stage had a very low value.

The aim of the invention is to provide a two-stage transconductance operational amplifier in CMOS technology in which frequency compensation does not create problems as in the case of known two-stage amplifiers.

The invention achieves this aim and other objects and advantages, as will become apparent from the continuation of the description, with a CMOS transconductance operational amplifier which comprises a first differential stage, which is formed by two transistors biased by a current source, the load of said transistors being a current mirror formed by two transistors, with an MCAS cascode, and a second single-ended stage which is driven by said first stage and is formed by a transistor which is biased by a current source, characterized in that in order to provide frequency compensation, a first capacitor is connected between the source of the cascode of the first stage and the output node of the second stage, and a second capacitor is connected between the output node of the second stage and the input node of the second stage.

The invention is now described in greater detail with reference to some preferred embodiments, illustrated only by way of non-limitative example in the accompanying drawings, wherein:

Fig. 1 is a circuit diagram of a two-stage transconductance operational amplifier according to the prior art;

Fig. 2 is an equivalent circuit diagram, for small signals, of the amplifier of Figure 1, useful for explaining the problems of the known art;

Fig. 3 is a circuit diagram of another two-stage transconductance operational amplifier according to the prior art; and

Fig. 4 is a circuit diagram of a two-stage transconductance operational amplifier according to a preferred embodiment of the invention.

With reference to Fig. 1, a two-stage transconductance operational amplifier, according to the prior art, comprises a first differential stage, which is formed by two transistors T1 and T2 which are biased by a current source T3 and the load of which is a current mirror formed by two transistors T4 and T5, and a second single-ended stage which is driven by the first stage and is formed by a transistor T6 biased by a current source T7. The amplifier is frequency-compensated by a capacitor $C_c$ which is connected between the output node of the first stage and the output node of the second stage.

From the analysis of the circuit of Fig. 1 and with the aid of Figure 2, it can be seen that in the frequency domain the transfer function of said circuit has the following three singularities (two poles and one zero):

$$p_d \approx -1/g_{m2}r_2C_cR_1, \quad p_2 \approx -g_{m2}/C_L(1+C_1/C_2), \quad z = g_{m2}/C_c,$$

where $g_{m1}$ is the transconductance of the differential stage, $C_1$ and $R_1$ are the output capacitance and resistance of the first stage, $g_{m2}$ is the transconductance of the second stage, $R_2$ is the output resistance of the second stage, $C_c$ is the compensation capacitance and $C_L$ is the total capacitance of the load.

The value $A_0$ of the gain is:

$$A_0 = g_{m1}R_1 g_{m2}R_2.$$

The cutoff frequency $f_T$ of the amplifier is given by:

$$2\pi.f_T \approx p_d.A_0 \approx g_{m1}/C_c.$$

It is apparent to the man of the art that in order to give a good degree of stability to the amplifier, the sum of the phase shifts introduced by the non-predominant singularities (in this case $p_2$ and $z$) at $f_T$ must be less than 45°. This means that the following must be true:

$$g_{m1}/C_c < \tfrac{1}{2}g_{m2}/C_L(1 + C_1/C_c).$$

Since it is not possible to have $g_{m2} \gg g_{m1}$ unless an enormous amount of area and power are used, $C_c$ must be of the same order of magnitude as $C_L$, and a reduced area occupation, a degraded slew-rate and a very small $f_T$ must be accepted.

As regards the zero, it is known to move it away (theoretically to infinity) by introducing a resistor $R_z$ in series to $C_c$, thus obtaining the following modified zero $z^*$:

$$z^* = 1/C_c(1/g_{m2} - R_z).$$

Since it is not practically possible to obtain exact equality between $1/g_{m2}$ and $R_d$, the zero creates a small phase shift at the frequency $f_T$.

Fig. 3 is a circuit diagram of a two-stage transconductance operational amplifier proposed by Ribner and Copeland, op. cit., to remedy the defects of the amplifier of Fig. 1. Said amplifier differs from the one of Fig. 1 in that it comprises an MCAS in the differential stage. This solution would be effective if the transconductance of the MCAS MOS cascode were very high and the parasite capacitor at the output of the first stage had a very low value, because (only in this case) the non-predominant pole becomes:

$$p_2 \approx - (g_{m2}/C_L)(C_c/C_1).$$

Since $C_c \gg C_1$, the stability condition

$$g_{m1}/C_c \ll (g_{m2}/C_L)(C_c/C_1)$$

would be widely met for values of $C_c$ much lower than in the case of Fig. 1, and the zero would furthermore move to very high frequencies, so as to not introduce phase shifts at the frequency $f_T$. Actually, however, the finite transconductance and the capacitors associated with the MCAS add a pole and produce a peaking of the frequency response, and the problem then moves to the gain margin instead of the phase margin. The known solution to this problem is to make $C_c$ higher than necessary, in order to reduce $f_T$ enough so that the peaking does not produce instability. However, in this way one partially loses the advantage of a reduced $C_c$ with respect to the case of Fig. 1.

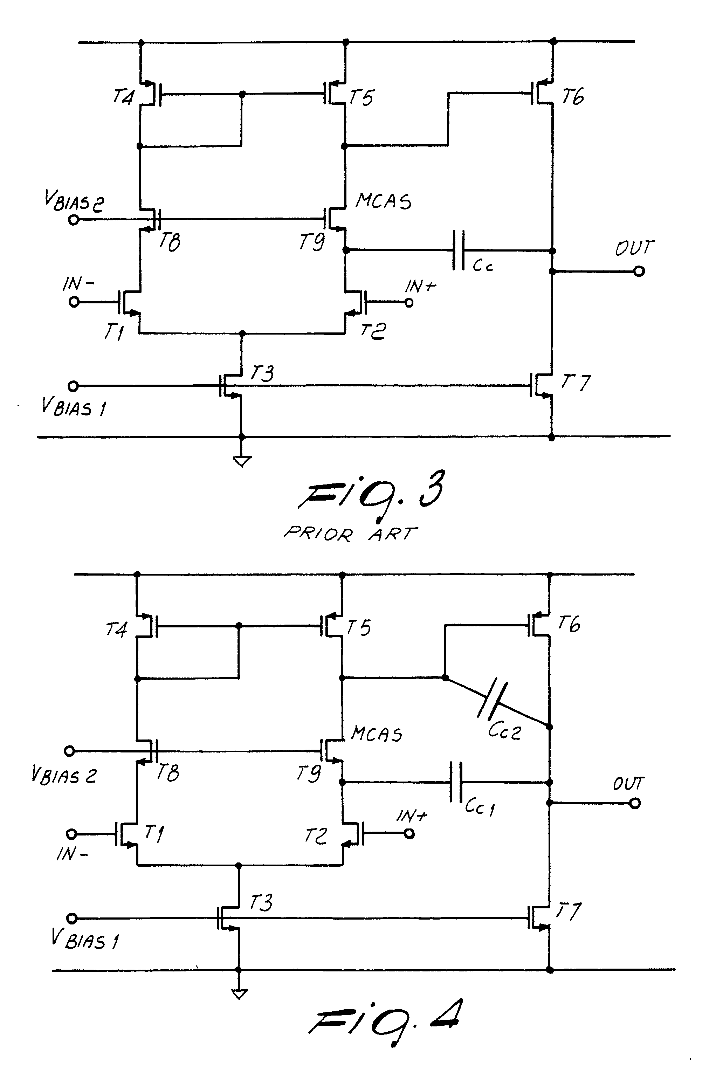

Fig. 4 is the circuit diagram of the present invention. As in Fig. 3, this solution comprises a first differential stage, which is formed by two transistors T1 and T2 which are biased by a current source T3 and have a load constituted by a current mirror formed by two transistors T4 and T5, and a second single-ended stage, which is driven by the first stage and is formed by a transistor T6 which is biased by a current source T7. Two transistors T8 and T9 form an MCAS cascode for the differential stage.

For frequency compensation, the amplifier according to the invention comprises a first capacitor $C_{c1}$ which is connected between the source of the MCAS cascode (drain of T2) of the first stage and the output node (drain of T6) of the second stage, and furthermore comprises a second capacitor $C_{c2}$ between the output node of the second stage (drain of T6) and the input node of the second stage (gate of T6).

The sum of the two capacitances of $C_{c1}$ and $C_{c2}$, with $C_{c1} > C_{c2}$, is equal to that of the single $C_c$ of Fig. 3. Therefore the circuit is not more expensive than the known one, and does not occupy more area. Nonetheless, the problem of peaking is considerably attenuated.

A preferred embodiment of the invention has been described, but it is understood that the expert in the field can devise other modifications and variations which are comprised within the scope of the inventive concept.

Where technical features mentioned in any claim are followed by reference signs, those reference signs have been included for the sole purpose of increasing the intelligibility of the claims and accordingly, such reference signs do not have any limiting effect on the scope of each element identified by way of example by such reference signs.

## Claims

1.  CMOS transconductance operational amplifier, comprising a first differential stage, which is formed by two transistors (T1 and T2) which are biased by a current source (T3), the load of said two transistors being a current mirror formed by two transistors (T4 and T5) with an MCAS cascode, and a second single-ended stage, which is driven by said first stage and is formed by a transistor (T6) which is biased by a current source (T7), characterized in that in order to provide frequency compensation, a first capacitor ($C_{c1}$) is connected between the source of the MCAS cascode of the first stage and the output node of the second stage, and a second capacitor ($C_{c2}$) is connected between the output node of the second stage and the input node of the second stage.

2.  Amplifier according to claim 1, characterized in that the first capacitor ($C_{c1}$) is greater than the second capacitor ($C_{c2}$).

Fig. 8

Fig. 11

Fig. 9

Fig. 3

PRIOR ART

Fig. 4

# EUROPEAN SEARCH REPORT

## EP 91 10 2238

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X | EP-A-0 188 090  (NEC CORPORATION)<br>* page 11, line 14 - page 20, line 3; figures 7, 10 *<br>– – – | 1,2 | H 03 F 1/08<br>H 03 F 3/45 |
| X | GB-A-2 126 817  (HITACHI LTD)<br>* page 4, lines 20 - 32; figure 1 *<br>– – – – – | 1 | |

TECHNICAL FIELDS
SEARCHED (Int. Cl.5)

H 03 F

The present search report has been drawn up for all claims

| Place of search | Date of completion of search | Examiner |
|---|---|---|
| The Hague | 15 April 91 | TYBERGHIEN G.M.P. |